# EUROPÄISCHE PATENTANMELDUNG

(11) **EP 1 180 794 A2**
(43) Veröffentlichungstag der Anmeldung: **20.02.2002**
(21) Anmeldenummer: 01117515.5
(22) Anmeldetag: 20.07.2001
(51) Int. Cl.: H01L 21/768, H01L 21/00

(54) **Prozessführung für eine Metall/Metall-Kontaktherstellung**

(30) Priorität: 18.08.2000 DE 10040465
(71) Anmelder: Infineon Technologies AG, 81669 München (DE)
(72) Erfinder: Schneegans, Manfred, Dr., 85591 Vaterstetten (DE); Wege, Stephan, 01474 Weissig (DE)
(74) Vertreter: Patentanwaltskanzlei WILHELM & BECK

(57) **Zusammenfassung**

Zur Herstellung von Metall/Metall-Kontakten im Rahmen einer Mehrlagenmetallisierung in einer integrierten Schaltung auf einer Halbleiterscheibe wird nach dem Aufbringen einer Isolationsschicht auf einer Metallebene ein Lithographieschritt mit einer Fotolackmaske zur Definition von Kontaktlöchern auf der Isolationsschicht und anschließend ein anisotropes Ätzen der Isolationsschicht zur Erzeugung der Kontaktlöcher ausgeführt. Dann wird in einem Vakuum nacheinander eine chemische Trockenätzung zur Beseitigung der Fotolackmaske und ein chemisch-physikalisches Trockenätzen zum Beseitigen vom beim chemischen Trockenätzen sich anlagernder organischer Verunreinigungen in einem Vakuum durchgeführt, um anschließend eine Metallabscheidung zur Kontaktlochauffüllung vorzunehmen.

## Beschreibung

Die Erfindung betrifft ein Verfahren zur Herstellung eines Metall/Metall-Kontaktes im Rahmen einer Mehrlagenmetallisierung in einer integrierten Schaltung auf einer Halbleiterscheibe und eine Vorrichtung zum Ausführen von Vorprozessen bei einer Metall/Metall-Kontaktherstellung im Rahmen einer Mehrlagenmetallisierung in einer integrierten Schaltung auf einer Halbleiterscheibe.

Bei der Verdrahtung von Schaltungselementen in einer integrierten Schaltung auf einer Halbleiterscheibe sind Techniken zur Verdrahtung in mehreren Ebenen übereinander entwickelt worden, die eine Einsparung die Chipfläche und eine Reduzierung der Leitbahnlängen bewirken. Bei integrierten Schaltungen auf Silizium-Basis werden zur Metallisierung vorwiegend die Metalle Aluminium und Kupfer verwendet, da diese aufgrund ihres geringen spezifischen Widerstands hohe Stromstärken ermöglichen. Zur Mehrlagenverdrahtung von integrierten Schaltungen werden die Metallebenen übereinander, jeweils durch Isolationsschichten voneinander getrennt angeordnet und über Kontaktöffnungen, sogenannten Vias, miteinander verbunden.

Die Metall/Metall-Kontakte werden dabei nach herkömmlicher Verfahrensweise in Planartechnik gefertigt. Hierzu wird auf einer bereits ausgebildeten Leiterbahnebene eine Isolationsschicht, vorzugsweise eine SiO₂-Schicht erzeugt. Anschließend wird ein lichtempfindlicher Lack aufgetragen, der dann über eine Maske mit der Struktur einer Entwurfsebene der Kontaktöffnungen belichtet wird. Dann wird der belichtete Lack entfernt und die SiO₂-Schicht anisotrop mit Hilfe einer Plasma-Ätzung geätzt. Anschließend wird die verbleibende Fotolackmaske wieder ganzflächig entfernt.

Die verwendeten Fotolacke enthalten als Hauptanteil überwiegend ein organisches Polymer, das sich vorzugsweise mit einer Plasma-Ätzschicht in einer Sauerstoffatmosphäre entfernen lässt. Bei der Plasma-Ätzung der SiO₂-Schicht zur Ausbildung des Kontaktloches und dem anschließenden Plasma-Ätzen der Fotolackmaske lagern sich jedoch üblicherweise Polymerreste im geätzten Kontaktloch ab, die vor einer Metallabscheidung zur Auffüllung des Kontaktlochs entfernt werden müssen. Der Reinigungsvorgang zur Polymer-Entfernung wird nach herkömmlicher Verfahrensweise als nasschemische Ätzung ausgeführt, bei der die Halbleiterscheibe in ein chemisches Bad getaucht wird. Der sich bei der nasschemischen Ätzung auf der Scheibenoberfläche anlagernde Feuchtfilm führt jedoch zu einer ungewünschten Oxidation der Metallbahnen im Bereich der Kontaktöffnung. Eine solche Oxidation wird auch noch dadurch hervorgerufen, dass beim Herausnehmen der Halbleiterscheibe aus dem chemischen Bad diese im allgemeinen mit Luft in Berührung kommt.

Vor der Metallabscheidung zur Kontaktlochauffüllung ist es deshalb erforderlich mit einem weiteren Ätzschritt, der vorzugsweise als Trockenätzung mit einem Argon-Plasma ausgeführt wird, das Oxid auf der Metallbahn im Kontaktloch zu entfernen. Dieser Ätzprozess führt jedoch zu einer ungewünschten Aufrauung der Kontaktfläche und darüber hinaus zu einer hohen Prozesstemperatur, die insbesondere eine Aluminiumabscheidung zur Auffüllung der Kontaktöffnung schwierig macht.

Die Gefahr einer Oxidation der Metalloberfläche im Kontaktloch besteht auch dann, wenn vor dem Abscheiden der SiO₂-Schicht zur Isolierung der Metallbahnen eine dünne Nitrid-Zwischenschicht eingebracht ist, wie dies insbesondere zur Passivierung von Kupferleitungsbahnen ausgeführt wird. Diese Nitrid-Schicht auf dem Kontaktlochboden wird nach herkömmlicher Verfahrensweise nach dem Entfernen der Polymerreste vorzugsweise mit einem Plasma-Ätzverfahren entfernt. Beim Transport der Halbleiterscheibe aus der Plasma-Ätzanlage in die Metall-Abscheideanlage entstehen jedoch auch ein Feuchtigkeitsfilm auf der Scheibenoberfläche, der zu einer Oxidation der Kontaktlochöffnungen führt, so dass auch hier vor der Metallabscheidung eine Oxidentfernung durchgeführt werden muss.

Aus der US 5,661,081, der US 6,025,255, der US 5,817,579 und der US 6,013,574 sind Verfahren zum Herstellen von Metall/ Metall-Kontakten im Rahmen einer Mehrlagenmetallisierung bekannt, bei denen eine Isolationsschicht auf einer Metallebene der Halbleiterscheibe aufgebracht wird, anschließend ein Fotolithographieschritt zur Definition der Kontaktlöcher ausgeführt wird, durch anisotropes Ätzen die Kontaktlöcher erzeugt werden, in einem darauffolgenden Reinigungsprozess die Fotolackmaske bzw. sich dabei bildende organische Verunreinigungen entfernt werden und schlussendlich im Rahmen einer Metallabscheidung die Kontaktlöcher aufgefüllt werden. Zwischen dem Reinigungsprozess zum Entfernen der Fotolackmaske und der sonstigen Verunreinigungen und dem Metallabscheiden bildet sich bei diesem bekannten Verfahren auf dem Kontaktlochboden eine Schicht, die vor dem Metallabscheiden durch eine zusätzliche Ätzung entfernt werden muss.

Aufgabe der vorliegenden Erfindung ist es die Prozessführung zur Metall/Metall-Kontaktherstellung in integrierten Schaltungen auf einer Halbleiterscheibe zu verbessern und insbesondere kostengünstiger zu gestalten.

Diese Aufgabe wird durch ein Verfahren zur Herstellung eines Metall/Metall-Kontaktes im Rahmen einer Mehrlagenmetallisierung in einer integrierten Schaltungen auf einer Halbleiterscheibe gemäß Anspruch 1 und einer Vorrichtung zum Ausführen der Vorprozesse bei der Metall/Metall-Kontaktherstellung gemäß Anspruch 7 gelöst. Bevorzugte Weiterbildungen sind in den abhängigen Ansprüchen angegeben.

Gemäß der Erfindung werden die Prozesse zur Herstellung von Metall/Metall-Kontakten im Rahmen einer Mehrlagenmetallisierung in einer integrierten Schaltung auf einer Halbleiterscheibe so geführt, dass nach dem Aufbringen einer Isolationsschicht auf einer Metallebene ein Lithographieschritt mit einer Fotolackmaske zur Definition von Kontaktlöchern auf der Isolationsschicht und anschließend ein anisotropes'Ätzen der Isolationsschicht zur Erzeugung der Kontaktlöcher ausgeführt wird. Dann wird in einem Vakuum nacheinander eine chemische Trockenätzung, vorzugsweise eine Plasma-Ätzung zur Beseitigung der Fotolackmaske, eine chemisch-physikalische Trockenätzung, vorzugsweise ein reaktives Ionen-Ätzen zur Beseitigung von sich beim Plasma-Ätzen anlagernden organischen Verunreinigungen und eine Metallabscheidung zur Kontaktlochauffüllung ausgeführt.

Mit dieser Prozessführung, bei der die Vorprozesse vor der Metallabscheidung zur Kontaktlochauffüllung ohne Unter brechung des Vakuums ausgeführt werden, kann auf einen zusätzlichen Prozessschritt zur Entfernung einer Oxid-Schicht im Kontaktlochboden verzichtet werden, wodurch sich die Prozessgeschwindigkeit wesentlich verbessert und sich darüber hinaus eine Kosteneinsparung erzielen lässt. Des weiteren kann durch die Vermeidung eines zusätzlichen Ätzprozesses zur Oxidentfernung die Scheiben-Temperatur vor einer Kontaktlochauffüllung niedrig gehalten werden.

Gemäß der Erfindung wird die Plasma-Ätzung zur Beseitigung der Fotolackschicht und das reaktive Ionen-Ätzen zur Beseitigung von beim Plasma-Ätzen sich anlagernden organischen Verunreinigungen in einer gemeinsamen Vakuumkammer ausgeführt, wodurch eine wesentliche Kosteneinsparung erzielt wird, die darüber hinaus auch zu einer Flächeneinsparung im Reinraum führt. Darüber hinaus kann auch auf einen zusätzlichen Scheiben-Transport, der die Gefahr einer Oxidation beinhalten würde, verzichtet werden.

Gemäß einer bevorzugten Ausführungsform wird die Fotolackmaske mit einem chemischen Trockenätzschritt von einem plasmaangeregtem Gasstrom isotrop abgeätzt und anschließend die sich anlagernden organischen Verunreinigungen mit einem chemischen-physikalischen Trockenätzschritt unter Ionenbeschuss entfernt. Diese beiden Ätztechniken lassen sich besonders einfach in einer Vakuumkammer unter Nutzung des im wesentlichen gleichen Equipments ausführen.

Gemäß einer weiteren bevorzugten Ausführungsform wird, wenn zur Metallisierung Kupfer eingesetzt wird, auch die Nitrid-Schicht am Kontaktlochboden mit einem ähnlichen chemischenphysikalischen Trockenätzschritt, wie der zum Entfernen der organischen Verunreinigungen, abgeätzt, wobei alle Ätzprozesse, nämlich das Entfernen der Fotolackmaske, das Ätzen der organischen Verunreinigungen und die Nitrid-Schicht-Entfernung, in einer gemeinsamen Vakuumkammer ausgeführt werden. Hierdurch werden die Gerätekosten und die Stellfläche im Reinraum wesentlich reduziert. Darüber hinaus kann auf einen zusätzlichen Scheiben-Transportprozess verzichtet werden.

Die Erfindung wird anhand der beigefügten Zeichnungen näher erläutert.

Es zeigen:
Figur 1A bis 1H eine erfindungsgemäße Prozessfolge zur Herstellung von Metall/Metall-Kontakten für eine integrierte Schaltung;
Figur 2 einen Vergleich einer herkömmlichen Standard-Prozessfolge mit einer erfindungsgemäßen integrierten Prozessfolge zur Herstellung von Kupfer-Kontakten;
Figur 3 einen Vergleich einer herkömmlichen Standard-Prozessfolge mit einer erfindungsgemäßen integrierten Prozessfolge zur Herstellung von Aluminium-Kontakten; und
Figur 4 eine erfindungsgemäße Prozesskammer.

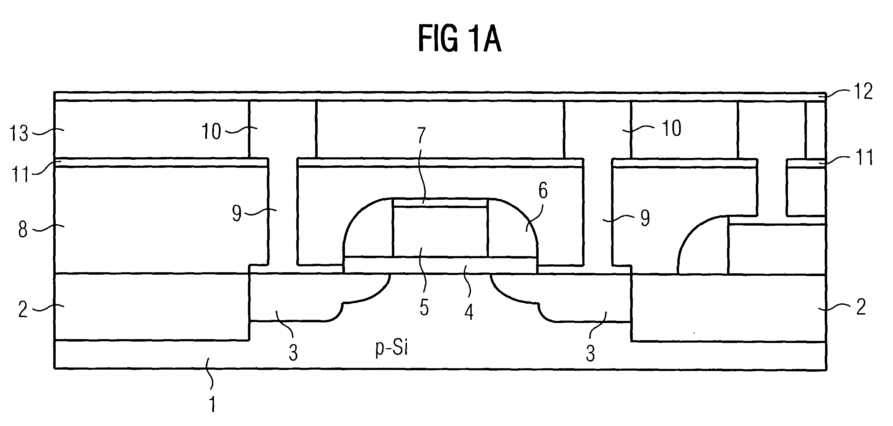

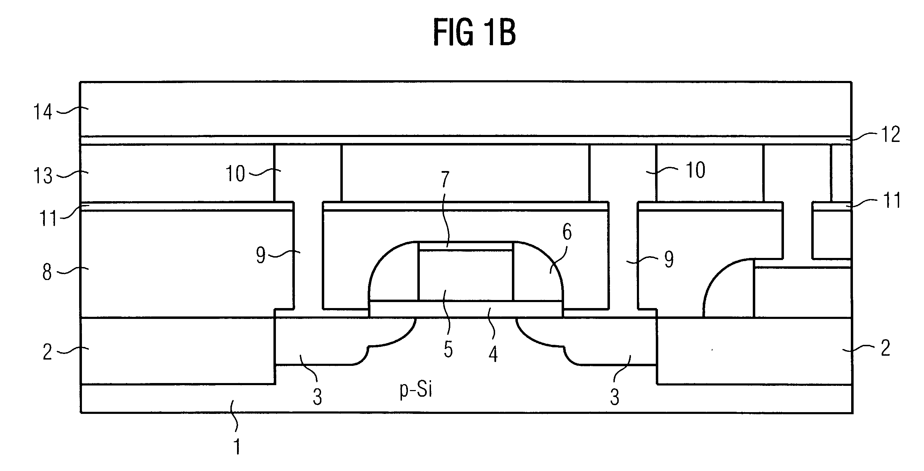

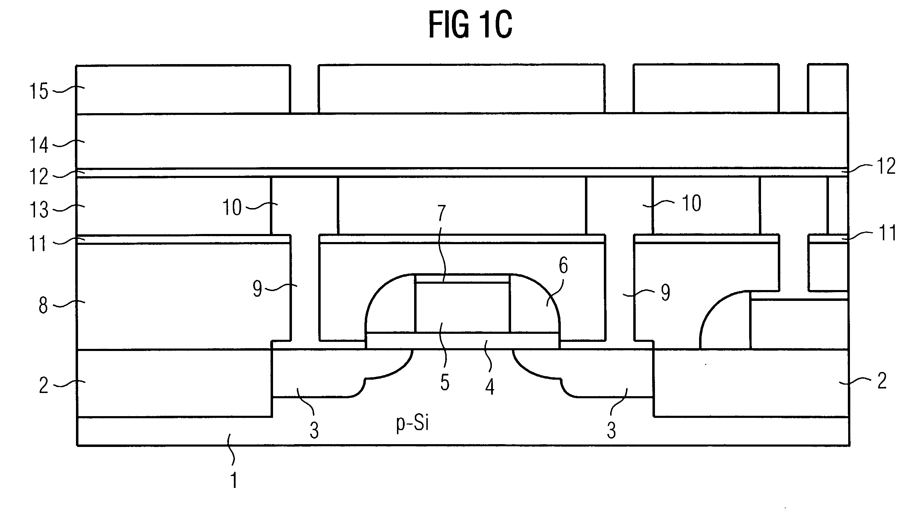

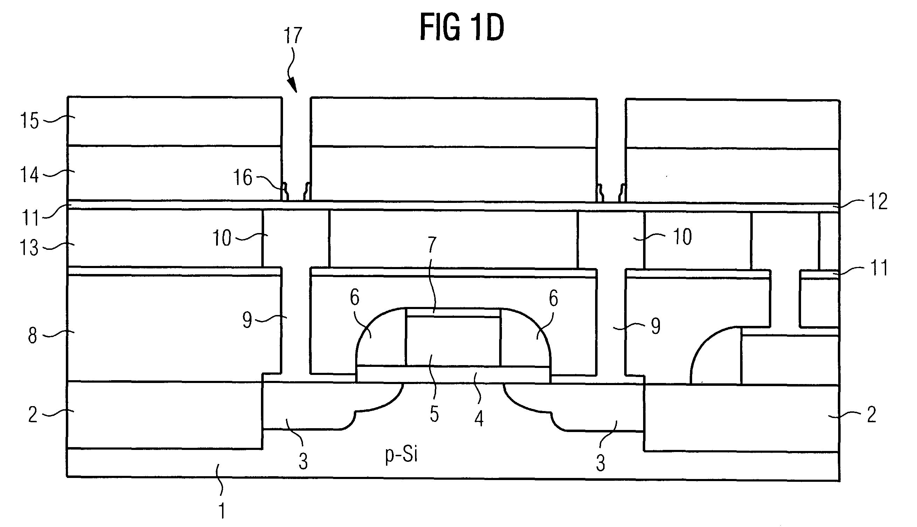

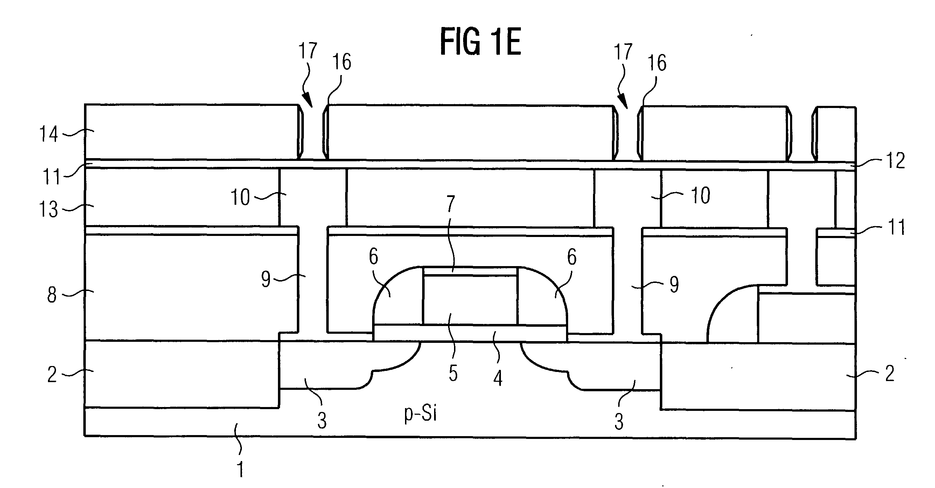

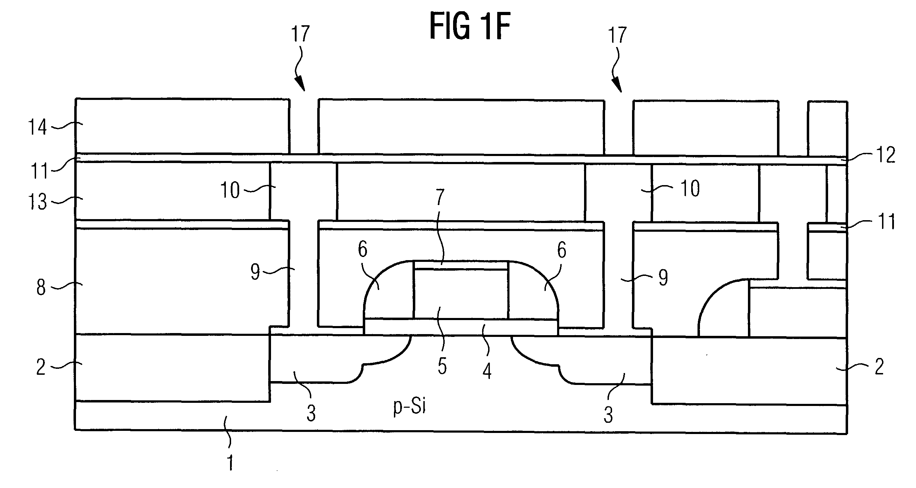

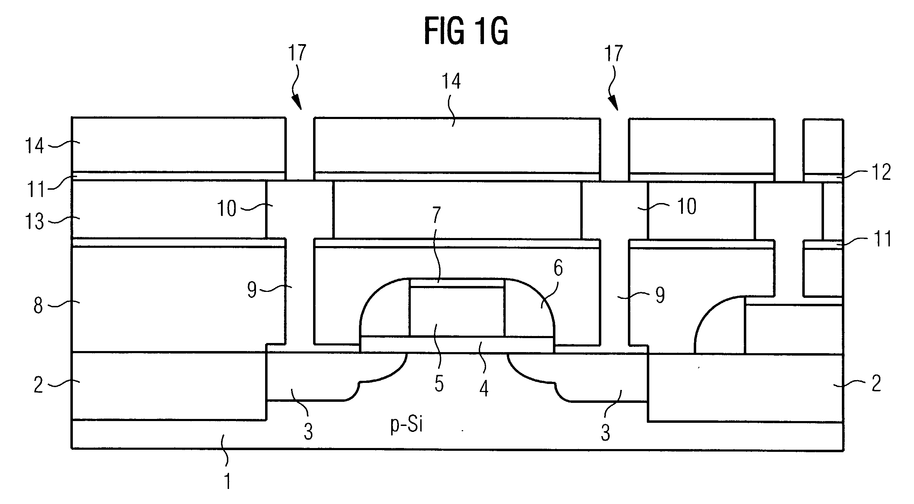

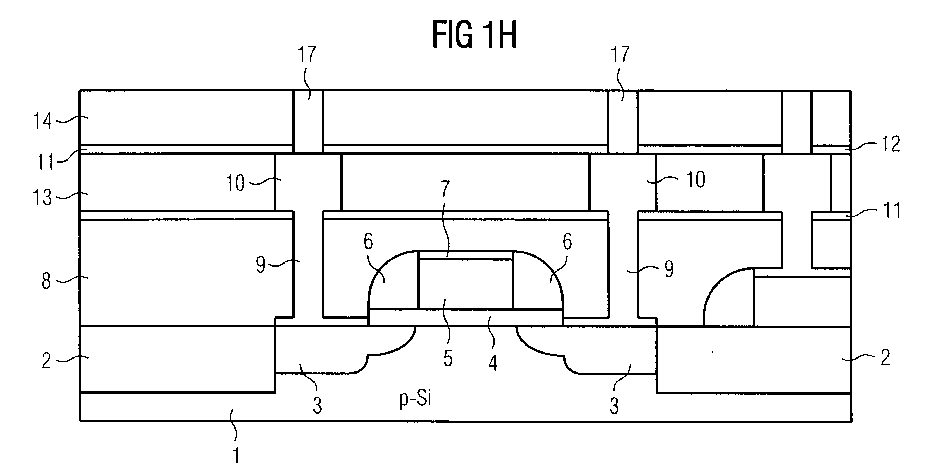

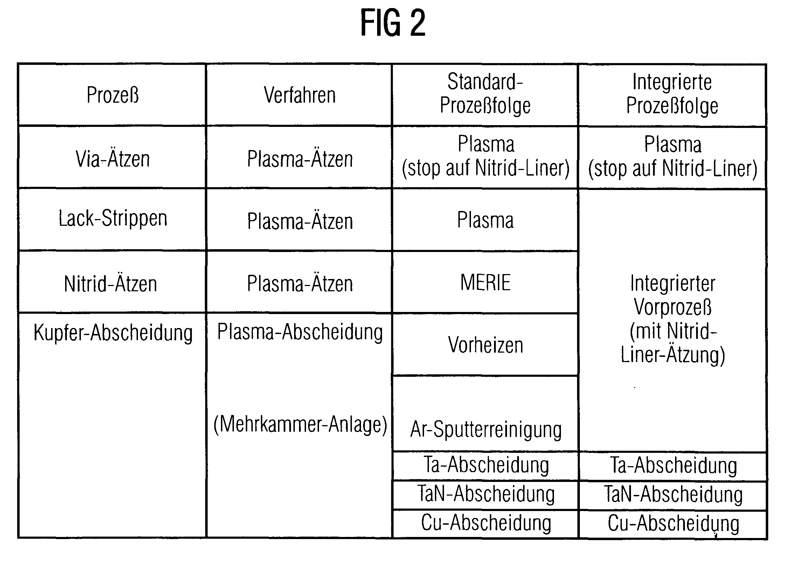

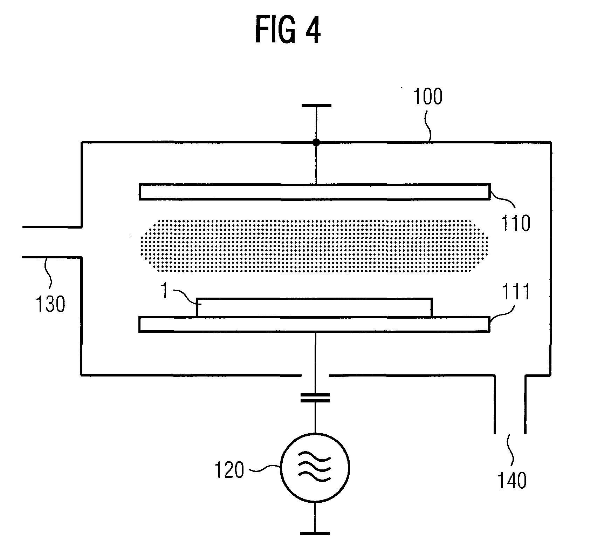

Die erfindungsgemäße integrierte Prozessfolge zur Herstellung von Metall/Metall-Kontakten im Rahmen einer Mehrlagenmetallisierung wird am Beispiel einer digitalen CMOS-Schaltung auf einer Halbleiterscheibe dargestellt, wobei die Kontaktierung einer ersten Metallisierungsebene mit einer zweiten Metallisierungsebene beschrieben wird. Bei der in Figur 1 gezeigten Prozessfolge wird dabei als Metall für die Leitungsbahnen Kupfer eingesetzt, das sich durch einen geringen spezifischen Widerstand auszeichnet und somit hohe Stromstärken zulässt. Figuren 1A bis 1H zeigen einen Querschnitt durch eine Silizium-Scheibe in verschiedenen Prozessstadien zur Ausbildung der Kupfer-Kontakte, Figur 2 einen Vergleich der erfindungsgemäßen Prozessfolge mit einer herkömmlichen Prozessfolge und Figur 4 eine mögliche Ausgestaltung einer erfindungsgemäßen Prozesskammer.

Figur 1A zeigt eine Silizium-Scheibe 1, die schwach p-dotiert ist und in der ein Feldeffekt-Transistor ausgebildet ist.

Dieser Feldeffekt-Transistor ist seitlich durch zwei dielektrische Schichten 2, die aus SiO₂ bestehen, begrenzt. Der Feldeffekt-Transistor weist zwei stark n-dotierte Diffusionsbereiche 3 auf, die als stromliefernde (Source) und stromaufnehmende (Drain) Elektroden dienen. Überlappend mit diesen beiden Elektrodenbereichen 3 ist eine dielektrische Schicht 4, vorzugsweise aus SiO₂, ausgebildet, auf der eine stromleitende Steuer-(Gate)-Elektrode 5, die z.B. aus hochdotierten Poly-Silizium besteht, sitzt. Diese Gate-Elektrode 5 ist durch zwei SiO₂-Spacer 6 begrenzt und über eine Leiterbahn 7, die vorzugsweise aus Wolframsilizid besteht, angeschlossen. Der gesamte Feldeffekt-Transistor ist weiterhin in eine Isolationsschicht 8, die vorzugsweise aus SiO₂ besteht, eingekapselt. Durch diese Isolationsschicht 8 hindurch sind Metallkontakte 9 eingebracht, die den Elektrodenbereich 3 kontaktieren. Die Metallkontakte 9 sind dabei mit Kupfer ausgefüllt und jeweils an eine Kupfer-Leiterbahn 10 angeschlossen. Diese Kupfer-Leiterbahnen 10 sind zwischen zwei Nitrid-Schichten 11, 12 eingeschlossen, die für eine Verkapselung des Kupfers sorgen, und zur elektrischen Isolierung von einer Dielektrikumsschicht 13, vorzugsweise aus SiO₂, umgeben. Ein Querschnitt durch die Silizium-Scheibe nach diesem Herstellungsstadium ist in Figur 1A gezeigt. Zur elektrischen Isolierung der ersten Leiterbahnebene 10 ist auf der oberen Nitrid-Schicht 12 eine weitere SiO₂-Schicht 14 aufgebracht. Ein Querschnitt durch die Silizium-Scheibe nach der SiO₂-Abscheidung ist in Figur 1B gezeigt.

Zur Ausbildung einer leitenden Verbindung zwischen der ersten Leiterbahnebene 10 aus Kupfer und einer zweiten Leiterbahnebene aus Kupfer wird nun in einem ersten Prozessschritt mit Hilfe der Lithographietechnik die Struktur der Leiterbahnkontakte definiert. Hierbei wird zuerst ein Haftvermittler auf die Nitrid-Schicht 12 aufgetragen und dann die Nitrid-Schicht 12 mit einem strahlungsempfindlichen Fotolack 15 beschichtet. Dieser Fotolack 15 ist im allgemeinen ein sogenannter Positiv-Fotolack und besteht aus einem festen Matrix-Material, einem lichtempfindlichen Anteil und einem Lösungsmittel. Das Matrix-Material ist dabei vornehmlich ein Phenol-Harz.

Nach dem Belacken der Silizium-Scheibe wird das Lösungsmittel aus der Fotolackschicht 15 durch einen Heizschritt ausgetrieben. Dann wird auf der Fotolackschicht 15 die Struktur der Kontaktöffnungen über das Belichten mit Hilfe einer Maske oder direkt durch ein Elektronenstrahl-Schreiben festgelegt. Der Fotolack 15 wird anschließend dann entwickelt. Während der Entwicklung löst sich in der Positiv-Fotolacktechnik der Fotolack an den belichteten Stellen auf, die nicht bestrahlten Bereiche bleiben maskiert. Ein Querschnitt durch die Silizium-Scheibe nach diesem Prozessschritt ist in Figur 1C gezeigt. Bei einer auch möglichen Negativ-Fotolacktechnik wären genau entgegengesetzt die belichteten Stellen maskiert, während der unbelichtete Lack beim Entwickeln aufgelöst wird. Nach dem Entwickeln des Fotolacks 15 erfolgt dann nochmals ein Temperaturschritt, um den Fotolack 15 auszuhärten.

Nach dem Lithographieprozess werden nun in einer Prozessfolge die Kontaktlöcher in die SiO₂-Schicht 14 geätzt, wobei die Fotolackschicht 15 als Maske dient, dann die Fotolackmaske wieder entfernt und anschließend die Nitrid-Schicht 12 am Kontaktlochboden abgeätzt. Alle Prozessvorgänge erfolgen vorzugsweise in Trockenätztechnik, wobei der Materialabtrag durch Atome bzw. Moleküle aus einem Gas und/oder durch Beschuss der zu ätzenden Oberfläche mit Ionen, Photonen oder Elektronen erfolgt. Die gesamte Prozessfolge wird dabei in einer einzelnen Prozesskammer durchgeführt, die Teil einer Metallabscheideanlage ist, wodurch eine integrierte Prozessführung ohne eine Unterbrechung des Vakuums möglich ist.

Eine erfindungsgemäße Prozesskammer ist in Figur 4 gezeigt. Diese Prozesskammer ist vorzugsweise direkt an eine Anlage zur Metallabscheidung angeschlossen, um einen Transport der Halbleiterscheibe aus der Prozesskammer in die Metallabscheideanlage ohne eine Unterbrechung des Vakuums durchführen zu können. Die Prozesskammer umfasst einen geschlossenen Behälter 100, ein Elektrodenpaar 110, 111, das an einen Hochfrequenzgenerator 120 angeschlossen ist, einem Einlass 130 für das Ätzgas und einen Anschluss 140 für die Vakuumpumpe. Die untere Elektrode 111 der vorzugsweise parallel angeordneten Elektroden dient gleichzeitig als Träger für die zu ätzende Halbleiterscheibe 1. Mit der gezeigten Prozesskammer kann sowohl ein chemisches Trockenätzen, bei dem eine chemische Reaktion zwischen neutralen Teilchen eines Gases und Atomen der zu ätzenden Oberfläche stattfindet, als auch ein chemischphysikalisches Trockenätzen, bei dem die chemische Ätzreaktion durch einen physikalischen Ätzprozess, der durch den Beschuss mit Ionen, Elektronen oder Photonen hervorgerufen wird, unterstützt werden. Der chemisch-physikalische Ätzprozess wird dabei vorzugsweise zum anisotropen Ätzen der Kontaktlöcher in die SiO₂-Schicht und dem anschließenden Reinigen der Kontaktlöcher von organischen Verunreinigungen eingesetzt, der chemische Ätzprozess dagegen zum flächigen Abätzen der Fotolackschicht.

Zum Ätzen wird die Reaktorkammer evakuiert und dann ein geeignetes Ätzgas zugeführt. Ein chemischer Ätzvorgang wird dabei mit einem angeregten Gas durchgeführt, wobei das Gas in der Zuführröhre durch Anlegen einer Hochfrequenzspannung (nicht gezeigt) in ein Plasma umgewandelt wird. Dieses Plasma wird über den Einlass 130 in die Kammer 100 eingespeist. Aus dem eingespeisten Plasma diffundieren angeregte neutrale Atome oder Moleküle zu der Halbleiterscheibe 1 und reagieren chemisch mit den Atomen auf der Scheibenoberfläche. Die Reaktionsprozesse werden dann mit Hilfe einer Vakuumpumpe über den Anschluss 140 abgesaugt. Beim chemischen Trockenätzen erfolgt der Ätzprozess richtungsunabhängig, so dass ein isotropes Ätzprofil entsteht.

Beim chemisch-physikalischen Trockenätzen wird das Ätzgas über die Zuführung 130 eingespeist und dann durch Anlegen einer Hochfrequenzspannung über den Hochfrequenzgenerator 120 an die beiden Elektroden 110, 111 eine Glimmentladung erzeugt, wobei ein Niederdruck- und Niedertemperaturplasma mit Ionen, Elektronen und angeregten neutralen Teilchen entsteht. Da die Elektronen sich im Hochfrequenzfeld schneller an den Elektroden anlagern, werden diese Elektroden dabei negativ aufgeladen und ziehen damit aus dem Plasma die positiven Ionen an. Diese senkrecht einfallenden Ionen lösen dann auf der Scheibenoberfläche eine chemische Ätzreaktion aus, wobei ein anisotropes Ätzprofil entsteht. Die Ätzprodukte werden wieder über den Anschluss 140 von der Vakuumpumpe abgesaugt.

In der in Figur 4 gezeigten Prozesskammer wird zum chemisch-physikalischen Trockenätzen die reaktive Ionenätztechnik verwendet, bei der die Hochfrequenzspannung kapazitiv an der unteren Elektrode 111 angelegt wird. Die obere Elektrode 110 ist mit der Reaktionskammer 100 verbunden und geerdet. Zusammen mit der Reaktionskammer 100 bildet die obere Elektrode 110 so eine größere Oberfläche als die untere, was zur Folge hat, dass die untere Elektrode stärker negativ von den auftreffenden Elektronen aufgeladen wird. Die Ionen aus dem Plasma erhalten damit auf dem Weg zur ätzenden Halbleiterscheibe eine genügend hohe chemische Energie zur Auflösung der chemischen Ätzreaktionen. Weiterhin kann der Gasdruck in der Reaktionskammer relativ niedrig gehalten werden, so dass die Ionen kaum zusammenstoßen und somit im wesentlichen senkrecht zur ätzenden Oberfläche gelangen und damit die Maske maßhaltig auf die darunterliegende Schicht auf der Halbleiterscheibe übertragen.

Anstelle eines reaktiven Ionenätzens besteht jedoch auch die Möglichkeit, andere bekannte Plasma-Ätztechniken zum chemisch-physikalischen Trockenätzen einzusetzen, wie z.B. das magnetfeldunterstützte reaktive Ionenätzen, das Trioden reaktive Ionenätzen oder das induktiv gekoppelte Plasma-Ätzen. Auch können verschiedenste Plasma- oder Ionenquellen, wie die Kaufmannquelle, die ECR-Quelle, die induktiv gekoppelte Quelle oder die Helikonquelle eingesetzt werden. Beim chemischen Trockenätzen besteht darüber hinaus neben einer Ätzgasanregung im Einlass 130 über eine Hochfrequenzspannung auch die Möglichkeit, ein Plasma durch Einkopplung von Mikrowellen in dem gasdurchströmten Einlass 130 zu erzeugen.

Zur Ätzung der Kontaktlöcher 17 in die SiO₂-Schicht 14 auf der Silizium-Scheibe 1 wird die Silizium-Scheibe, nachdem sie in die Reaktorkammer 100 eingebracht ist, mit einem ersten reaktiven Ionen-Ätzschritt anisotrop geätzt, wobei als Ätzmaske die Fotolackschicht 15 dient. SiO₂ wird dabei meist mit einem fluorhaltigen Gas geätzt, das selektiv zur darunterliegenden Nitrid-Schicht 12 ist. Dem fluorhaltigen Ätzgas wird darüber hinaus zur verbesserten Ätzung Zusätze beigefügt, wie z.B. H₂, O₂, CH₄ etc. Die Silizium-Scheibe nach diesem Ätzschritt ist in Figur 1D gezeigt. Es verbleiben in den Kontaktlöchern 16 jedoch ungewünschte Polymerbeläge 16, die sich aus den Reaktionsprodukten des Ätzvorgangs bilden.

Nach dem Kontaktlochätzen wird die verbleibende Fotolackschicht 15, die als Maske gedient hat, wieder entfernt. Hierzu wird ein trocken-chemischer Ätzprozess durchgeführt, der für eine isotrope Abätzung der Fotolackschicht 15 sorgt. Als Ätzgas wird dabei vorzugsweise Sauerstoff, gegebenenfalls mit Zusätzen, eingesetzt. Auch bei diesem isotropen Ätzvorgang entstehen wiederum Polymerbeläge 16 in den Kontaktlochöffnungen 17, wie der Querschnitt durch die Silizium-Scheibe in Figur 1E zeigt.

Diese polymeren Beläge 16 werden mit einem weiteren reaktiven Ionen-Ätzschritt entfernt. Hierzu wird als Ätzgas wiederum vorzugsweise Sauerstoff eingesetzt, wobei zur Stabilisierung des Plasmas im allgemeinen ein Edelgas, vor allem Argon, zugesetzt wird. Als Ätzmaske dient dabei die verbleibende SiO₂-Schicht 14. Ein Querschnitt durch die Silizium-Scheibe 1 nach diesem weiteren reaktiven Ionen-Ätzprozess ist in Figur 1F gezeigt.

Anschließend wird dann ebenfalls mittels eines reaktiven Ionen-Ätzschritts die verbleibende Nitrid-Schicht 12 am Kontaktlochboden geöffnet, um so einen Zugang zu den Kupferleiterbahnen zu schaffen. Auch hierbei wird vorzugsweise ein fluorhaltiges Gas zur Ätzung eingesetzt. Ein Querschnitt durch die Silizium-Scheibe nach diesem Prozessschritt ist in Figur 1G gezeigt.

Die gesamte Ätzfolge nach der Kontaktlochätzung in die SiO₂-Schicht 14 , d.h. die Entfernung der Fotolackmaske 15 und das Abtragung der Nitrid-Schicht 12 am Kontaktlochboden werden in der Reaktionskammer 100 ohne eine Unterbrechung des Vakuums geführt. Da die Reaktionskammer 100 Teil der Metallabscheideanlage ist wird dieses Vakuum auch für die sich daran anschließende Metallabscheidung nicht unterbrochen. Hierdurch wird verhindert, dass sich beim Transport und Lagern an Luft Feuchtigkeitsfilme auf der Scheibenoberfläche bilden, die zu einer Oxidation in der Kontaktlochöffnung führen könnten und die dann mit einem zusätzlichen Reinigungsschritt entfernt werden müssten. Durch die integrierte Prozessfolge kann deshalb auf solche aufwendigen und teuren zusätzlichen Reinigungsschritte verzichtet werden. Durch die integrierte Prozessführung in einer gemeinsamen Reaktionskammer wird darüber hinaus der Aufwand zur Ausführung der einzelnen Prozessschritte wesentlich reduziert, da sowohl auf ein eigenständiges Equipment als auch auf zusätzliche Stellflächen im Reinraum verzichtet werden kann.

Nach Abschluss der Ätzprozesse erfolgt dann, wie in Figur 1H dargestellt, ein Auffüllen der Kontaktlöcher 16 mit Kupfer, wobei vor der Kupferabscheidung eine Schichtenfolge aus Ta und TaN aufgebracht wird, die als Diffusionsbarriere und Keimschicht für die anschließende Kupferabscheidung dienen. Nach Abschluss der Kupferabscheidung wird dann gemäß einem der bekannten Verfahren eine Strukturierung dieser Kupfer-Schicht zum Ausbilden weiterer Leiterbahnen vorgenommen.

Figur 2 zeigt eine Gegenüberstellung der herkömmlichen Standard-Prozessfolge und der erfindungsgemäßen integrierten Prozessfolge bei einer Kupfermetallisierung. Bei der Standard-Prozessfolge werden alle Ätzschritte in eigenständigen Ätzkammern durchgeführt und vor der Kupfer-Abscheidung eine Argon-Sputterreinigung der vorgeheizten Scheibe zur Abtragung sich in den Kontaktlochöffnungen bildenden Oxid-Schichten vorgenommen. Auf den Heizschritt und die anschließende Sputterreinigung mit Argon kann bei der erfindungsgemäßen integrierten Prozessfolge verzichtet werden.

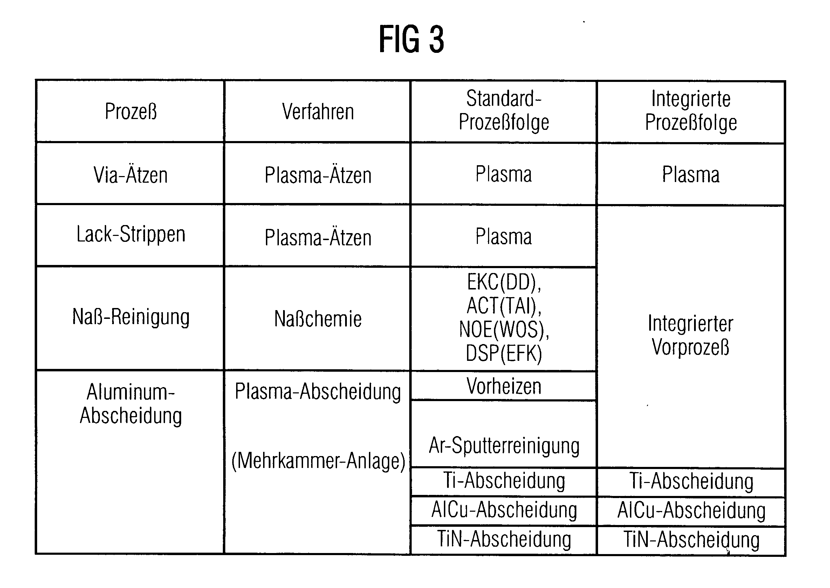

Figur 3 zeigt eine weitere Gegenüberstellung einer herkömmlichen Prozessfolge und der erfindungsgemäßen integrierten Prozessfolge, bei der die Metallisierung mit Aluminium vorgenommen wird. Bei einer Ausbildung der Leiterbahnen mit Aluminium kann auf eine Nitrid-Schicht zur Abkapselung der Leiterbahnen, wie sie bei Kupfer verwendet wird, verzichtet werden. Bei den herkömmlichen Verfahren wird jedoch eine zusätzliche nasschemische Reinigung nach dem chemischen Trockenätzen der Fotolackschicht vorgenommen, um sich bildende Polymere zu entfernen. Dieser Prozessschritt wird gemäß der Erfindung durch ein reaktives Ionen-Ätzen in derselben Vakuumanlage ersetzt, was den Vorteil hat, dass sich keine Oxid-Schichten in den Kontaktlochöffnungen bilden, die vor der Aluminium-Abscheidung dann wieder durch ein zusätzliches Argon-Sputterprozess entfernt werden müssen.

Es liegt weiterhin im Rahmen der Erfindung über die dargestellten Ausführungsbeispiele hinaus insbesondere die angegebenen Materialien und Prozesse in geeigneter Weise zu modifizieren, um erfindungsgemäß einen Metall/Metall-Kontakt im Rahmen einer Mehrlagenmetallisierung in integrierten Schaltungen auf einer Halbleiterscheibe zu erzeugen. Insbesondere kann dabei auf bekannte Prozessfolgen zur Ausbildung von Mehrlagenmetallisierungen für integrierte Schaltungen zurückgegriffen werden. Die in der vorstehenden Beschreibung, den Zeichnungen und den Ansprüchen offenbarten Merkmale der Erfindung können sowohl einzeln als auch in beliebiger Kombination für die Verwirklichung der Erfindung in ihren verschiedenen Ausgestaltungen von Bedeutung sein.

## Patentansprüche

1. Verfahren zum Herstellen eines Metall/Metall-Kontaktes im Rahmen einer Mehrlagenmetallisierung in einer integrierten Schaltung auf einer Halbleiterscheibe (1) mit den Verfahrensschritten:
Aufbringen einer Isolationsschicht (14) auf einer Metallebene (10),
Ausführen eines Fotolithographieschrittes mit einer Fotolackmaske (15) zur Definition von Kontaktlöchern (17) auf der Isolationsschicht (14),
anisotropes Ätzen der Isolationsschicht (14) zur Erzeugung der Kontaktlöcher (17),
chemisches Trockenätzen zur Beseitigung der Fotolackmaske (15) in einem Vakuum,
chemisches-physikalisches Trockenätzen zum Beseitigen von beim Trockenätzen sich anlagernden organischen Verunreinigungen (16) im Vakuum, und
Metallabscheiden zum Auffüllen der Kontaktlöcher (17),
wobei das chemisches Trockenätzen zur Beseitigung der Fotolackmaske (15), das chemisches-physikalisches Trockenätzen zum Beseitigen von beim Trockenätzen sich anlagernden organischen Verunreinigungen (16) und das Metallabscheiden zum Auffüllen der Kontaktlöcher (17) ohne Unterbrechung des Vakuums durchgeführt wird.

2. Verfahren nach Anspruch 1, wobei das chemische Trockenätzen zur Beseitigung der Fotolackmaske (15) mit einem Ätzgas durchgeführt wird, das durch Anlegen einer Hochfrequenzspannung oder durch eine Mikrowelleneinkopplung zu einem Plasma angeregt ist.

3. Verfahren nach Anspruch 1 oder 2, wobei das chemisch-physikalische Trockenätzen zum Beseitigen der organischen Verunreinigungen (16) mit einer reaktiven Ionenätztechnik durchgeführt wird.

4. Verfahren nach einem der Ansprüche 1 bis 3, wobei beim chemischen Trockenätzen zur Beseitigung der Fotolackmaske (15) Sauerstoff als Ätzgas eingesetzt wird.

5. Verfahren nach einem der Ansprüche 1 bis 4, wobei zur Metallisierung Kupfer eingesetzt wird und nach dem chemisch-physikalischen Trockenätzen zum Beseitigen organischer Verunreinigungen ein weiterer chemisch-physikalischer Trockenätzschritt im Vakuum zum Entfernen einer Nitrid-Schicht (12) am Kontaktlochboden ausgeführt wird.

6. Vorrichtung zum Herstellen eines Metall/Metall-Kontaktes im Rahmen einer Mehrlagenmetallisierung in einer integrierten Schaltung auf einer Halbleiterscheibe (1) gemäß einem der Ansprüche 1 bis 5, umfassend eine Prozesskammer mit einem Behälter (100), der einen Prozessgaseinlass (130), einen Anschluss (140) für eine Vakuumpumpe, Elektroden (110, 111) für eine Hochfrequenzerzeugung und einen Scheibenträger (111) aufweist, wobei der Behälter (100) zum Durchführen nacheinander in einem Vakuum einer chemischen Trockenätzung zum Beseitigen einer Fotolackschicht (15), die als Maske zur Definition von Kontaktlöchern (17) auf einer Isolationsschicht (14), die auf einer Metallebene (10) auf einer Halbleiterscheibe (1) angeordnet ist, dient, und einer chemisch-physikalisches Trockenätzen zum Beseitigen von beim Plasma-Ätzen sich anlagernder organischer Verunreinigungen (16) in den Kontaktlöchern geeignet ist, und wobei die Prozesskammer und die Teil einer Anlage zur Metallabscheidung ist, um einen Transport der Halbleiterscheibe aus der in die Metallabscheideanlage ohne eine Unterbrechung des Vakuums durchführen zu können.
